(19) **Europäisches Patentamt**
**European Patent Office**
**Office européen des brevets**

(11) **EP 2 724 467 B1**

(12) **FASCICULE DE BREVET EUROPEEN**

(45) Date de publication et mention
de la délivrance du brevet:
**19.12.2018 Bulletin 2018/51**

(21) Numéro de dépôt: **12735225.0**

(22) Date de dépôt: **21.06.2012**

(51) Int Cl.:
*H03M 13/11* (2006.01)     *H03M 13/13* (2006.01)
*H03M 13/15* (2006.01)     *H03M 13/17* (2006.01)
*H03M 13/27* (2006.01)     *H03M 13/29* (2006.01)
*H03M 13/05* (2006.01)     *H04L 1/00* (2006.01)
*H03M 13/00* (2006.01)

(86) Numéro de dépôt international:
**PCT/EP2012/061923**

(87) Numéro de publication internationale:
**WO 2012/175589 (27.12.2012 Gazette 2012/52)**

(54) **PROCÉDÉ D'ENCODAGE DE DONNÉES D'INFORMATION EN BURSTS**

VERFAHREN ZUR DATENKODIERUNG IN BURSTS

METHOD FOR ENCODING DATA IN BURSTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.06.2011 FR 1155444**

(43) Date de publication de la demande:
**30.04.2014 Bulletin 2014/18**

(73) Titulaire: **Centre National d'Etudes Spatiales 75039 Paris Cedex 01 (FR)**

(72) Inventeurs:
• **SMITH, Guillaume**
**F-78580 Les Alluets Le Roi (FR)**
• **LACAN, Jérôme**
**F-31400 Toulouse (FR)**
• **CLARAC, Laurence**
**F-31400 Toulouse (FR)**

(74) Mandataire: **Gaillarde, Frédéric F. Ch. et al Cabinet Germain & Maureau 31-33, rue de la Baume 75008 Paris (FR)**

(56) Documents cités:
**US-A- 5 870 412**

• **"Digital Video Broadcasting (DVB); Upper Layer FEC for DVB Systems", TECHNICAL REPORT, EUROPEAN TELECOMMUNICATIONS STANDARDS INSTITUTE (ETSI), 650, ROUTE DES LUCIOLES ; F-06921 SOPHIA-ANTIPOLIS ; FRANCE, vol. BROADCAS, no. V1.1.1, 1 février 2011 (2011-02-01), XP014064504,**
• **Mohamed Amine Ismail ET AL: "A Multi-Burst Sliding Encoding for Mobile Satellite TV Broadcasting", Rapport de Recherche numero 6785, INRIA, Thème COM - Systèmes Communicants, Équipe-Projets Planete, inria-00349223, Version 1, 24 décembre 2008 (2008-12-24), pages 1-24, XP055007412, Domaine de Voluceau - Rocquencourt, BP 105 - 78153 Le Chesnay Cedex - France - ISSN 0249-6399 Extrait de l'Internet: URL:http://hal.inria.fr/docs/00/34/92/23/P DF/RR-6785.pdf [extrait le 2011-09-16]**

EP 2 724 467 B1

## Description

### Domaine technique

La présente invention concerne le champ technologique de la transmission de données par bursts (encore appelés « rafales » ou « salves »), et plus particulièrement la protection des données à transmettre contre des erreurs de transmission, notamment la perte de bursts entiers.

### Etat de la technique

Dans le contexte du présent document, des bursts sont des ensembles de symboles représentant des données à transmettre. Chaque burst est transmis pendant un intervalle de temps typiquement court par rapport au temps de latence entre la transmission de deux bursts successifs d'un même service. Les séquences de bursts de plusieurs services (p.ex. de différentes chaînes de télévision) peuvent être entrelacées, mais cela sera sans importance dans la suite. Chaque burst comprend une section de données (comprenant un ou plusieurs blocs de symboles d'information) et une section de protection d'erreurs (comprenant un ou plusieurs blocs de symboles de redondance). Lors de la transmission, il peut se produire des erreurs de symboles de deux types : des symboles erronés sont reçus ou des symboles sont perdus (ou « effacés »). Les blocs de symboles de redondance constituent un code de protection contre des erreurs.

La transmission de données par bursts se fait, par exemple, dans le cadre d'un système DVB (de l'anglais : digital video broadcasting, diffusion vidéo numérique).

Une solution classique pour la génération d'un bloc de symboles de redondance d'un burst consiste à appliquer une fonction de codage sur le bloc de symboles d'information du même burst. Il s'agit là d'une protection d'erreurs « intra-burst », qui permet au récepteur de corriger des erreurs de transmission à l'intérieur du bloc de symboles d'information d'un burst reçu. Pour que cette approche puisse fonctionner, il faut que le burst à corriger arrive à destination. On utilise la protection « intra-burst » notamment dans la diffusion vidéo numérique, par exemple selon la norme DVB-H (de l'anglais : digital video broadcasting - handheld). La protection « intra-burst » n'est pas adaptée à des effacements de bursts entiers dans la séquence de bursts reçus. Or de telles situations sont assez fréquentes pour certaines liaisons de communication, par exemple entre un satellite et un terminal mobile.

Le document US 2009/0006927 propose une protection « inter-bursts » qui permet de remédier à la perte de bursts entiers. Selon le procédé de ce document, les paquets de données sont groupés selon des niveaux de priorité. Des mots de code de correction d'erreurs spécifiques à chaque groupe sont générés sur les paquets de données, appartenant au groupe, d'au moins deux bursts d'un premier ensemble de bursts. Les codes de correction ainsi obtenus sont transmis dans la section de correction d'erreurs d'au moins un burst d'un second ensemble de bursts.

Le document US 2010/0031121 décrit aussi un procédé de protection « inter-bursts », dans lequel un mot de code de correction d'erreurs est calculé sur la base de données entrelacées provenant d'une pluralité de bursts d'un flux de données élémentaire. Le document US 5,870,412 divulgue un procédé de protection « inter-paquets », dans lequel on rattache à chaque paquet un code de correction d'erreurs qui se compose de la somme XOR (« OU » logique exclusif) d'un nombre (>1) prédéterminé de paquets de charge utile précédents.

Le document ETSI TS 102 584 V1.1.1 (2008-12), « Digital Video Broadcasting (DVB); DVB-SH Implementation Guidelines » disponible sur le site web du European Télécommunications Standards Institute (ETSI) décrit un procédé de protection « inter-bursts » (voir en particulier les illustrations aux pages 62 et 63). Selon ce procédé, chaque burst transmis contient une section de correction d'erreurs calculée sur la base de données entrelacées de plusieurs bursts antérieurs. Chaque burst de datagrammes est réparti sur B matrices d'encodage. Un mot de code de correction d'erreurs est calculé pour chaque matrice d'encodage et rattaché à un burst de datagrammes, éventuellement après entrelacement avec un ou plusieurs autres mots de codes de correction d'erreurs. Chaque donnée n'est protégée qu'une seule fois, c.-à-d. elle n'entre dans le calcul que d'un seul mot de code de correction d'erreurs. De tels procédés d'encodage similaires sont également connus des documents ETSI TR 102 993 V.1.1.1 (2011-02) et « A Multi-Burst Sliding Encoding for Mobile Satellite TV Broadcasting » de M. Ismail et autres, Rapport de recherche N°6785, INRIA. Ces documents décrivent des procédés MPE-IFEC (produisant une protection « inter-bursts »), dans lesquels les mots de code de correction d'erreurs sont entrelacés entre eux avant que les blocs ainsi obtenus soient rattachés aux bursts de datagrammes. Comme dans les références précédentes, chaque donnée n'est protégée qu'une seule fois, c.-à-d. elle n'entre dans le calcul que d'un seul mot de code de correction d'erreurs.

### Objet de l'invention

Un objet de la présente invention est d'atteindre une meilleure protection des données dans un système de communication par bursts.

## Description générale de l'invention

La présente invention concerne un procédé d'encodage de données d'information en une séquence de bursts décliné selon plusieurs aspects et variantes, tels que repris aux revendications indépendantes 1, 3, 4 et 6.

Il est proposé un procédé d'encodage de données d'information en une séquence de bursts, dont chaque burst comprend un bloc de symboles d'information et un bloc de symboles de redondance (c.-à-d. un bloc de protection ou de mot de code correcteur). Le procédé implémente une protection « inter-bursts » du fait que le bloc de symboles de redondance du burst actuel de la séquence est généré à partir de symboles d'information des blocs de symboles d'information de plusieurs bursts de la séquence. Selon l'invention, la génération du bloc de symboles de redondance du burst actuel comprend le calcul d'une somme (vectorielle, c.-à-d. coordonnée par coordonnée dans le cas d'une représentation par coordonnées) d'une série de valeurs de codage relative à une série de bursts, chaque valeur de codage de la série de valeurs de codage étant obtenue par une fonction de codage respective, appliquée au bloc de symboles d'information du burst correspondant de la série de bursts.

Par exemple, si la série de bursts comprend les deux bursts précédant immédiatement le burst actuel, une première valeur de codage est calculée sur le bloc de symboles d'informations du burst immédiatement antérieur au burst actuel et une deuxième valeur de codage est calculée sur le bloc de symboles d'informations du burst qui se trouve dans la séquence de bursts à deux positions devant le burst actuel. Le bloc de symboles de redondance du burst actuel est obtenu, dans cet exemple, par addition vectorielle des première et deuxième valeurs de codage.

Notons que dans le contexte du présent document, le terme « codage » ou « code » concerne uniquement la notion de codage correcteur. Une fonction de codage est donc une fonction qui, appliquée sur un bloc de symboles, donne les symboles de redondance d'un code correcteur (par exemple de type Reed-Solomon, turbo-code, LDCP, BCH, Reed-Muller, Raptor, RaptorQ etc.) y afférent. Il convient de noter que l'invention repose principalement sur la fonction de codage qui utilise tous les symboles du bloc sur lequel elle est appliquée au sens que, si on change la valeur d'un seul, quelconque, symbole du bloc, la valeur de codage (le résultat de l'application de la fonction de codage sur le bloc de symboles) change aussi. En ce qui concerne la valeur de codage, on note qu'elle correspond normalement à un vecteur de symboles, c.-à-d. un nombre composé de plusieurs symboles. La fonction de codage peut correspondre à la multiplication par une matrice génératrice d'un code correcteur (par exemple de type Reed-Solomon, turbo-code, LDCP, BCH, Reed-Muller, Raptor, RaptorQ etc.). Selon l'invention, la fonction de codage correspond à la multiplication par une sous-matrice d'une telle matrice génératrice.

Il convient également de noter que le terme « information » est utilisé dans le présent contexte pour distinguer des symboles de redondance les données ou symboles à protéger (c.-à-d. des blocs données ou symboles de redondance). L'utilisation du terme «d'information » n'implique donc pas nécessairement que les symboles, blocs, etc. ainsi qualifiés véhiculent effectivement de l'information (bien que ce soit normalement le cas), voire uniquement de l'information. Par exemple, une partie des symboles d'information pourrait être des symboles de remplissage (en anglais : « padding ») rajoutés pour atteindre une taille de bloc prédéfinie.

La série de bursts peut être une série de bursts précédant, p. ex. immédiatement, le burst actuel. En pratique, on préférera toutefois, que la série de bursts soit une série de bursts suivant (p. ex. immédiatement) le burst actuel. La série de bursts pourrait aussi s'étendre avant et après le burst actuel (celui-ci pouvant faire partie de la série ou non).

Selon un mode de réalisation avantageux de l'invention, chaque burst comprend une structure ordonnée de blocs de symboles d'information et une structure ordonnée de blocs de symboles de redondance, le nombre (dit « profondeur d'entrelacement » du codage) de blocs de symboles d'information dans la structure ordonnée de blocs de symboles d'information étant égal au nombre de blocs de symboles de redondance dans la structure ordonnée de blocs de symboles de redondance. La génération d'un bloc se trouvant à une certaine position de la structure ordonnée de blocs de symboles de redondance du burst actuel comprend alors le calcul d'une somme d'une série de valeurs de codage relative aux blocs se trouvant à la position correspondante dans la structure ordonnée de blocs de symboles d'information des bursts de la série de bursts. Chaque valeur de codage de la série de valeurs de codage est dans ce cas obtenue par une fonction de codage respective, appliquée au bloc de symboles d'information se trouvant à la position correspondante dans la structure ordonnée de blocs de symboles d'information du burst correspondant de la série de bursts. Il convient de noter que les blocs de symboles d'information ne sont pas nécessairement tous de la même taille. Il en est de même pour les blocs de symboles de redondance.

Si, dans l'exemple précédent, chaque burst contient une suite de blocs de symboles d'information et une suite de blocs de symboles de redondance, la première valeur de codage est calculée pour chacun des blocs de symboles d'informations du burst immédiatement antérieur au burst actuel et la deuxième valeur de codage est calculée pour chacun des blocs de symboles d'informations du burst qui se trouve dans la séquence de bursts à deux positions devant le burst actuel. Le bloc de symboles de redondance du burst actuel se trouvant à une position « i » dans la suite est obtenu par addition des première et deuxième valeurs de codage calculées sur les blocs de symboles d'information à la position « i » dans les bursts précédents.

Le principal intérêt du procédé selon l'invention est que tous les symboles d'information d'un même burst sont protégés par les mêmes données de redondance, alors que dans une protection inter-burst classique (voir le document ETSI TS 102 584 V1.1.1), ces symboles sont intégrés dans des mots de code différents, ce qui génère des différences de correction.

Selon une variante avantageuse de l'invention la génération du bloc de symboles de redondance du burst actuel comprend la génération d'un premier et d'un deuxième (et éventuellement d'autres) sous-blocs du bloc de symboles de redondance du burst actuel. La génération du premier sous-bloc inclut :

   o le calcul d'une valeur de codage par une fonction de codage appliquée sur le bloc de symboles d'information d'un burst autre que le burst actuel, ou
   o le calcul d'une somme d'une première série de valeurs de codage relative à une première série de bursts, chaque valeur de codage de la première série de valeurs de codage étant obtenue par une fonction de codage respective, appliquée au bloc de symboles d'information du burst correspondant de la première série de bursts.

La génération du deuxième sous-bloc du bloc de symboles de redondance du burst actuel inclut le calcul d'une somme d'une deuxième série de valeurs de codage relative à une deuxième série de bursts, chaque valeur de codage de la deuxième série de valeurs de codage étant obtenue par une fonction de codage respective, appliquée au bloc de symboles d'information du burst correspondant de la deuxième série de bursts. Selon cet aspect de l'invention les première et deuxième séries de bursts sont de longueur différente.

Selon cette variante, le premier et le second sous-blocs du bloc de symboles de redondance se calculent donc à partir de séries différentes de burst antérieurs au burst actuel. Les première et deuxième séries de bursts peuvent être des séries de burst précédant, p.ex. immédiatement, le burst actuel (mais de longueur différente). Elles peuvent aussi être des séries suivant, p.ex. immédiatement, le burst actuel dans la séquence. Selon une autre variante, lune des séries précède le burst actuel, l'autre le suit. L'une et/ou l'autre des séries pourrait aussi s'étendre de part et d'autre du burst actuel.

L'avantage de cette variante est de proposer un bon compromis entre la capacité de correction du système, qui est meilleure lorsque la série de bursts est longue, et le délai de décodage, qui est meilleur lorsque la série de bursts est courte. Ce compromis permet de satisfaire simultanément plusieurs récepteurs observant des niveaux de bruit différents.

Considérons maintenant le cas où chaque burst comprend un nombre de blocs de symboles d'information et le même nombre de blocs de symboles de redondance, qui sont organisés en des structures ordonnées respectives. Dans ce cas, la génération d'un bloc de symboles de redondance en une position « i » dans la structure ordonnée de blocs de symboles de redondance du burst actuel comprend la génération d'un premier sous-bloc et d'un deuxième sous-bloc ; la génération du premier sous-bloc incluant :

   o le calcul d'une valeur de codage par une fonction de codage appliquée sur le bloc de symboles d'information se trouvant à la position « i » dans la structure ordonnée du burst autre que le burst actuel, ou

   o le calcul d'une somme d'une première série de valeurs de codage relative aux blocs se trouvant à la position « i » dans la structure ordonnée de blocs de symboles d'information des bursts de la première série de bursts, chaque valeur de codage de la première série de valeurs de codage étant obtenue par une fonction de codage respective, appliquée au bloc de symboles d'information se trouvant à la position « i » dans la structure ordonnée de blocs de symboles d'information du burst correspondant de la première série de bursts ;

et la génération du deuxième sous-bloc incluant le calcul d'une somme d'une deuxième série de valeurs de codage relative aux blocs se trouvant à la position « i » dans la structure ordonnée de blocs de symboles d'information des bursts de la deuxième série de bursts, chaque valeur de codage de la deuxième série de valeurs de codage étant obtenue par une fonction de codage respective, appliquée au bloc de symboles d'information se trouvant à la position « i » dans la structure ordonnée de blocs de symboles d'information du burst correspondant de la deuxième série de bursts.

Il sera apprécié que l'étape de génération du bloc de symboles de redondance puisse être répétée pour un ou plusieurs bursts suivants qui deviennent à tour de rôle le burst actuel.

De préférence, les fonctions de codage restent inchangées lors de la répétition de l'étape de génération du bloc de symboles de redondance pour les bursts suivants. Dans l'alternative, les fonctions de codage sont changées de manière cyclique lors de la répétition de l'étape de génération du bloc de symboles de redondance pour les bursts suivants.

Le nombre de blocs de symboles d'information dans la structure ordonnée de blocs de symboles d'information est avantageusement compris dans la plage de 1 à 1000.

Les symboles d'information et les symboles de redondance sont typiquement des éléments d'un corps fini **F**, tel que par exemple $F_2$ ou $F_{256}$.

## Brève description des dessins

D'autres particularités et caractéristiques de l'invention ressortiront de la description détaillée de quelques modes de réalisation avantageux présentés ci-dessous, à titre d'illustration, en se référant aux dessins annexés. Ceux-ci montrent:

Fig. 1: un diagramme en fonction du temps d'une séquence de bursts ;

Fig. 2: une illustration de la structure interne d'un burst ;

Fig. 3: une illustration schématique d'un premier mode de réalisation préféré de l'invention ;

Fig. 4: une illustration schématique d'un deuxième mode de réalisation préféré de l'invention.

## Description d'une exécution préférée

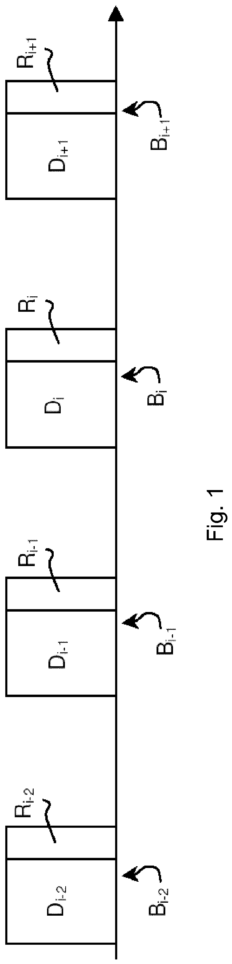

La figure 1 montre une séquence de bursts $B_{i-2}$, $B_{i-1}$, $B_i$, $B_{i+1}$, dont chaque burst comporte une section de données $D_{i-2}$, $D_{i-1}$, $D_i$, respectivement $D_{i+1}$ et une section de protection d'erreurs $R_{i-2}$, $R_{i-1}$, $R_i$, respectivement $R_{i+1}$.

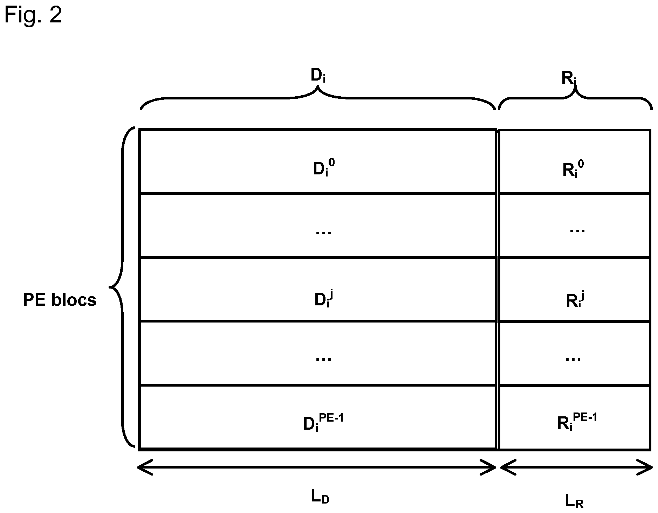

La structure interne d'un burst est montrée plus en détail à la figure 2. La section de données $D_i$ du burst $B_i$ comprend PE blocs de symboles d'information $D_{i,0}$, $D_i^1$, $D_i^2$,..., $D_i^j$, ..., $D_i^{PE-1}$. Chaque bloc $D_i^j$, $j = 0$, ..., PE-1, contient $L_D$ symboles éléments d'un corps fini $F$ (par exemple $F_2$ ou $F_{256}$). De manière similaire, la section de protection d'erreurs $R_i$ comprend PE blocs de symboles de redondance $R_i^0$, $R_i^1$, $R_i^2$,..., $R_i^j$, ..., $R_i^{PE-1}$. Chaque bloc $R_i^j$, $j = 0$, ..., PE-1, contient $L_R$ symboles éléments du corps fini $F$.

Dans la suite, des modes de réalisation de l'invention seront d'abord illustrés pour le cas PE = 1. Pour faciliter la notation, l'indice supérieur j, c.-à-d. le numéro du bloc de symboles d'information ou de redondance considéré, sera omis.

Une solution classique pour obtenir le bloc de symboles de redondance $R_i$ pour le burst $B_i$ consiste à appliquer une fonction de codage f sur le bloc de symboles d'information $D_i$; on note: $R_i = f(D_i)$. Les symboles $r_u^{(i)}$, $u = 0$, ..., $L_R$-1, du bloc $R_i$ étant des éléments du corps fini $F$, on a :

$$r_u^{(i)} = \sum_{v=0}^{L_D-1} \alpha_{u,v} \cdot d_v^{(i)} \, ,$$

où les $d_v^{(i)}$, $v = 0$, ..., $L_D$-1, sont les symboles du bloc $D_i$ (et donc des éléments du corps fini $F$) et où les $\alpha_{u,v}$ sont les coefficients dans $F$ de la matrice génératrice $\underline{A}_i$ du code correcteur (de la fonction de codage), par exemple de type Reed-Solomon, turbo-code, LDPC, BCH, Reed-Muller, Raptor, RaptorQ ou autre. On a donc : $R_i = D_i \underline{A}_i$, où $R_i$ et $D_i$ sont considérés comme des vecteurs ligne.

Selon un mode de réalisation préféré de l'invention, on propose de construire le bloc de redondance $R_i$ du burst $B_i$ à partir des blocs de symboles d'information $D_{i-s}$, ..., $D_{i-s+(t-1)}$ d'une série de t bursts précédant le burst actuel $B_i$ dans la séquence. Le nombre s est un entier indiquant le début de la série des t bursts, avec $s \geq t$. Concrètement, on obtient le bloc de symboles de redondance $R_i$ du burst actuel par addition (définie sur $F^{L_R}$) d'une série de valeurs de codage $(C_w)_w = i-s$,..., i-s+(t-1) relative à la série de bursts $(B_w)_w = i-s$,..., i-s+(t-1) précédant le burst actuel $B_i$, chaque valeur de codage $C_w$ étant obtenue par une fonction de codage respective, appliquée au bloc de symboles d'information $D_w$ du burst $B_w$.

Formellement, pour un burst $B_i$ donné, on a :

$$c_u^{(w)} = \sum_{v=0}^{L_D-1} \alpha_{u,v}^{(w)} \cdot d_v^{(w)} \quad \text{et} \quad r_u^{(i)} = \sum_{w=i-s}^{i-s+(t-1)} c_u^{(w)} \, ,$$

où les $c_u^{(w)}$, u = 0, ..., $L_R$-1 sont les coefficients dans **F** du vecteur $C_w$ et où les $\alpha_{u,v}^{(w)}$, u = 0, ..., $L_R$-1, v = 0, ..., $L_D$-1, sont les coefficients dans **F** de la matrice génératrice $\underline{\underline{A}}_w$ du code correcteur (c.-à-d. de la fonction de codage) associé à la position w de la série de bursts $(B_w)_{w=i-s}$, ..., i-s+(t-1). Les symboles $r_u^{(i)}$, u = 0, ..., $L_R$-1, désignent de nouveau les coefficients dans **F** du bloc $R_i$. On peut écrire :

$$R_i = \sum_{w=i-s}^{i-s+(t-1)} D_w \underline{\underline{A}}_w \ .$$

Une première manière d'obtenir les coefficients des matrices génératrices $\underline{\underline{A}}_w$, w = i-s, ..., i-s+(t-1), est d'effectuer un tirage aléatoire.

Pour construire les matrices génératrices $\underline{\underline{A}}_w$ d'une autre manière, considérons une matrice génératrice d'un code correcteur classique Reed-Solomon, turbo-code, LDPC, BCH, Reed-Muller, Raptor, RaptorQ ou similaire, à t·$L_D$ lignes et t·$L_R$ colonnes. Cette matrice génératrice, que nous noterons $\underline{\underline{M}}$, caractérise de manière unique un code linéaire systématique de dimensions k·n, k = t·$L_D$ étant la longueur du message et n = t·$L_D$ + t $L_R$ la dimension du code. La matrice $\underline{\underline{M}}$ se laisse découper en t·t sous-matrices $\underline{\underline{M}}_{\mu,v}$, $\mu$ = 0, ..., t-1 et v = 0, ..., t-1, dont chacune contient $L_D$ lignes et $L_R$ colonnes :

$$\underline{\underline{M}} = \begin{bmatrix} \underline{\underline{M}}_{0,0} & \underline{\underline{M}}_{0,1} & \cdots & \underline{\underline{M}}_{0,t-1} \\ \underline{\underline{M}}_{1,0} & \underline{\underline{M}}_{1,1} & & \vdots \\ \vdots & & \ddots & \vdots \\ \underline{\underline{M}}_{t-1,0} & \cdots & \cdots & \underline{\underline{M}}_{t-1,t-1} \end{bmatrix}$$

Il est proposé de calculer les blocs de redondance $R_i$ de la manière suivante :

$$R_i = \sum_{\beta=0}^{t-1} D_{i-s+\beta} \underline{\underline{M}}_{\overline{i-s+\beta},i} \ .$$

où la notation « $\bar{x}$ » représente « x modulo t ». Pout un i donné, on obtient pour les matrices génératrices $\underline{\underline{A}}_w$, w = i-s, ..., i-s+(t-1) la relation $\underline{\underline{A}}_{i-s+\beta} = \underline{\underline{M}}_{\overline{i-s+\beta},i}$, $\beta$ = 0, ..., t-1. Il faut noter que selon cette construction, la position (absolue) i du burst $B_i$ dans la séquence de bursts est importante, car le code correcteur en dépend, sauf si $\underline{\underline{M}}_{\overline{\mu,v}} = \underline{\underline{M}}_{\overline{\mu+1},\overline{v+1}}, \forall \mu,v$. Si $\underline{\underline{M}}_{\overline{\mu,v}} = \underline{\underline{M}}_{\overline{\mu+1},\overline{v+1}} \forall \mu,v$, les fonctions de codage restent inchangées lors de la répétition de l'étape de génération du bloc de symboles de redondance pour les bursts suivants. Autrement, au fur et à mesure que l'index i augmente, les fonctions de codage changent cycliquement, avec une période t.

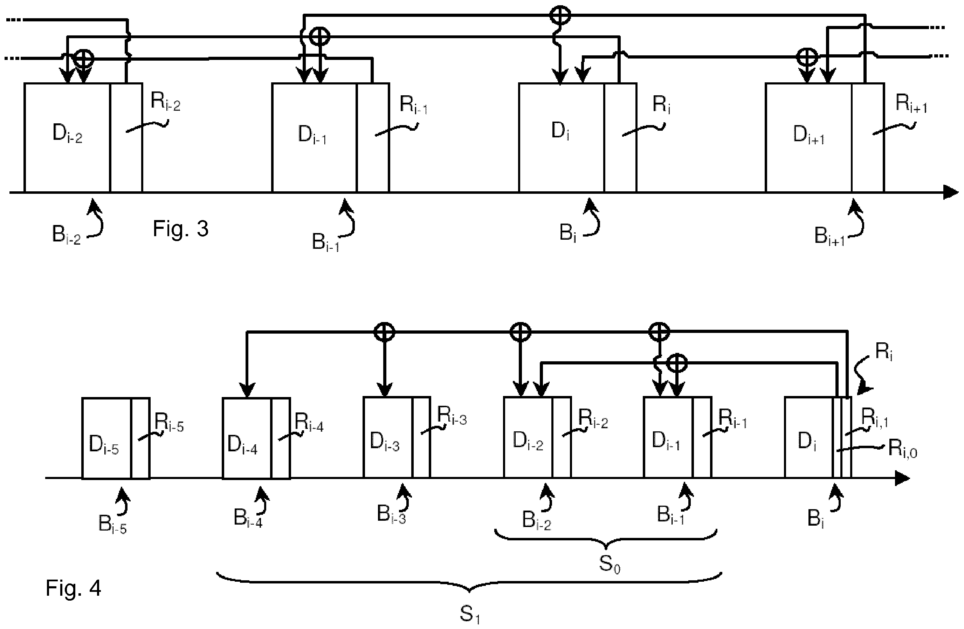

La figure 3 illustre de manière schématique les dépendances des blocs de symboles de redondance $R_i$ pour le cas où t = 2 et s = 2. Concrètement, on peut écrire : $R_2 = D_0 \underline{\underline{M}}_{0,0} + D_1 \underline{\underline{M}}_{1,0}$ ; $R_3 = D_1 \underline{\underline{M}}_{1,1} + D_2 \underline{\underline{M}}_{0,1}$ ; $R_4 = D_2 \underline{\underline{M}}_{0,0} + D_3 \underline{\underline{M}}_{1,0}$ ; $R_5 = D_3 \underline{\underline{M}}_{1,1} + D_4 \underline{\underline{M}}_{0,1}$ ; ..., ce qui peut être visualisé à l'aide du tableau suivant :

|       | $R_2$              | $R_3$              | $R_4$              | $R_5$              | ...  |
|-------|--------------------|--------------------|--------------------|--------------------|------|
| $D_0$ | $\underline{\underline{M}}_{0,0}$ |                    |                    |                    |      |
| $D_1$ | $\underline{\underline{M}}_{1,0}$ | $\underline{\underline{M}}_{1,1}$ |                    |                    |      |
| $D_2$ |                    | $\underline{\underline{M}}_{0,1}$ | $\underline{\underline{M}}_{0,0}$ |                    |      |
| $D_3$ |                    |                    | $\underline{\underline{M}}_{1,0}$ | $\underline{\underline{M}}_{1,1}$ |      |
| $D_4$ |                    |                    |                    | $\underline{\underline{M}}_{0,1}$ | ⋱   |
| ...   |                    |                    |                    |                    | ⋱   |

Le bloc de symboles de redondance d'une colonne x du tableau s'obtient par le calcul de la somme des produits matriciels des blocs de symboles d'information de la première colonne du tableau avec les matrices respectives de la colonne x.

En adoptant une notation plus classique, où [.] représente un vecteur ou une matrice :

$$[...,R_3,R_4,R_5,...] = [...,D_0,D_1,D_2,...] \cdot \begin{bmatrix} \ddots & \ddots & \cdots & & \cdots & 0 \\ \ddots & \underline{\underline{M}}_{0,0} & 0 & & & \vdots \\ \ddots & \underline{\underline{M}}_{1,0} & \underline{\underline{M}}_{1,1} & 0 & & \\ \vdots & 0 & \underline{\underline{M}}_{0,1} & \underline{\underline{M}}_{0,0} & 0 & \\ & 0 & \underline{\underline{M}}_{1,0} & \underline{\underline{M}}_{1,1} & \ddots & \vdots \\ \vdots & & 0 & \underline{\underline{M}}_{0,1} & \ddots & 0 \\ 0 & \cdots & & \cdots & 0 & \ddots & \ddots \end{bmatrix}$$

Comme indiqué plus haut, la matrice

$$\underline{\underline{M}} = \begin{bmatrix} \underline{\underline{M}}_{0,0} & \underline{\underline{M}}_{0,1} \\ \underline{\underline{M}}_{1,0} & \underline{\underline{M}}_{1,1} \end{bmatrix}$$

est issue de préférence d'un code correcteur classique.

L'intérêt de cette construction est que, lors du décodage, on fait apparaître les sous-matrices $\underline{\underline{M}}_{\mu,v}$ de la matrice de base $\underline{\underline{M}}$, ce qui permet d'utiliser les propriétés du code correspondant, notamment au niveau de l'algorithme de décodage, et de profiter de la capacité de correction de ce code. Par exemple, si les bursts $B_0$, $B_1$, $B_3$ et $B_4$ sont reçus, on peut retrouver le bloc de symboles d'informations $D_2$ du burst $B_2$ à l'aide des équations $R_3 = D_1 \underline{\underline{M}}_{1,1} + D_2 \underline{\underline{M}}_{0,1}$ et $R_4 = D_2 \underline{\underline{M}}_{0,0} + D_3 \underline{\underline{M}}_{1,0}$, ce qui fera apparaître les matrices $\underline{\underline{M}}_{0,0}$ et $\underline{\underline{M}}_{0,1}$ qui forment une sous-matrice de la matrice $\underline{\underline{M}}$. Si, par exemple, le code correcteur choisi est un code Reed-Solomon (optimal pour un canal à effacement), la récupération est optimale, c.-à-d. tous les symboles de redondance sont utiles.

La figure 4 est une illustration schématique d'un deuxième mode de réalisation préféré de l'invention. Selon ce mode de réalisation, les blocs de symboles de redondance sont à chaque fois composés de $Z \geq 2$ sous-blocs $R_{i,z}$, z=0,1,...,Z-1 ce que la figure 4 ne montre explicitement que pour le bloc $R_i$ avec des sous-blocs $R_{i,0}$ et $R_{i,1}$. La longueur de chaque sous-bloc $R_{i,z}$ est notée $L_z$. $L_z$ ne dépend pas de i et on a : $L_{z=0} + L_{z=1} + ... + L_{z=Z} = L_R$. Dans le présent exemple, on propose de construire les sous-blocs de redondance $R_{i,z}$ du burst $B_i$ à chaque fois de manière analogue au premier mode de réalisation de l'invention, c.-à-d. à partir des blocs de symboles d'information $D_{i-s(z)}$, ..., $D_{i-S(z)+(t(z)-1)}$ d'une série de t(z) bursts précédant le burst actuel $B_i$ dans la séquence. Le nombre s(z) est un entier indiquant le début de la série des t(z) bursts, avec $s(z) \geq t(z)$, pour tout z = 0, ..., Z-1. Concrètement, on obtient le sous-bloc de symboles de redondance $R_{i,z}$ du burst actuel par addition (définie sur $\mathbf{F}^{L_z}$) d'une série de valeurs de codage $(C_w)_{w = i-s(z)}$, ..., $_{i-s(z)+(t(z)-i)}$ relative à la série de bursts $(B_w)_{w = i-s(z),...,i-s(z)+(t(z)-i)}$ précédant le burst actuel $B_i$, chaque valeur de codage $C_w$ étant obtenue par une fonction de codage respective, appliquée au bloc de symboles d'information $D_w$ du burst $B_w$.

Formellement, pour un $z \in \{0,...,Z\}$ et un burst $B_i$ donnés, on a :

$$c_u^{(w)} = \sum_{v=0}^{L_D-1} a_{u,v}^{(w)} \cdot d_v^{(w)} \text{ et } r_u^{(i)} = \sum_{w=i-s}^{i-s(z)+(t(z)-1)} c_u^{(w)}$$

où les $c_u^{(w)}$, u = 0, ..., $L_z$-1 sont les coefficients dans $\mathbf{F}$ du vecteur $C_w$ et où les $a_{u,v}^{(w)}$, u = 0, ..., $L_z$-1, v = 0, ..., $L_D$-1, sont les coefficients dans $\mathbf{F}$ de la matrice génératrice $\underline{\underline{A}}_{w,z}$ du code correcteur (c.-à-d. de la fonction de codage) associé à la position w de la série de bursts $(B_w)_w = _{i-s(z)}$, ..., $_{i-s(z)+(t(z)-i)}$. Les symboles $r_u^{(i)}$, u = 0, ..., $L_z$-1, désignent ici les coefficients dans $\mathbf{F}$ du bloc $R_{i,z}$. On peut écrire :

$$R_{i,z} = \sum_{w=i-s(z)}^{i-s(z)+(t(z)-1)} D_w \underline{\underline{A}}_{w,z} \; .$$

Les matrices génératrices $\underline{\underline{A}}_{w,z}$ peuvent être construites, individuellement pour chaque $z \in \{0,...,Z\}$ de manière analogue aux matrices $A_w$ discutées ci-dessus, avec substitution de t(z) au lieu de t. On obtient ainsi Z systèmes de codage indépendants. On pourrait même les implémenter sur des corps finis différents.

Considérons par exemple une matrice génératrice $\underline{\underline{M(z)}}$ de $t(z) \cdot L_D$ lignes et $t(z) \cdot L_z$ colonnes d'un code correcteur. La matrice $\underline{\underline{M(z)}}$ se laisse découper en $t(z) \cdot t(z)$ sous-matrices $\underline{\underline{M(z)}}\mu,v$ $\mu = 0, ..., t(z)-1$ et $v = 0, ..., t(z)-1$, dont chacune contient $L_D$ lignes et $L_z$ colonnes :

$$\underline{\underline{M(z)}} = \begin{bmatrix} \underline{\underline{M(z)}}_{0,0} & \underline{\underline{M(z)}}_{0,1} & \cdots & \underline{\underline{M(z)}}_{0,t(z)-1} \\ \underline{\underline{M(z)}}_{1,0} & \underline{\underline{M(z)}}_{1,1} & & \vdots \\ \vdots & & \ddots & \vdots \\ \underline{\underline{M(z)}}_{t(z)-1,0} & \cdots & \cdots & \underline{\underline{M(z)}}_{t(z)-1,t(z)-1} \end{bmatrix}$$

Les sous-blocs de redondance $R_{i,z}$ peuvent être obtenus par :

$$R_{i,z} = \sum_{\beta=0}^{t(z)-1} D_{i-s(z)+\beta} \underline{\underline{M(z)}}_{\overline{i-s(z)+\beta},i} \; .$$

où la notation « $\overline{x}$ » représente ici « x modulo t(z) ».

Dans l'exemple illustré à la figure 4, le sous-bloc de redondance $R_{i,0}$ se calcule sur la base des blocs de symboles d'information des bursts de la série $S_0$ (s(0) = t(0) = 2) tandis que le sous-bloc de redondance $R_{i,1}$ se calcule sur la base des blocs de symboles d'information des bursts de la série $S_1$ ((s(1) = t(1) = 4). On peut donc écrire : $R_{4,0}$ = $D_2$ $\underline{\underline{M(0)}}_{0,0}$ + $D_3$ $\underline{\underline{M(0)}}_{1,0}$ ; $R_{4,1}$ = $D_0$ $\underline{\underline{M(1)}}_{0,0}$ + $D_1$ $\underline{\underline{M(1)}}_{1,0}$ + $D_2$ $\underline{\underline{M(1)}}_{2,0}$ + $D_3$ $\underline{\underline{M(1)}}_{3,0}$; $R_{5,0}$ = $D_3$ $\underline{\underline{M(0)}}_{1,1}$ + $D_4$ $\underline{\underline{M(0)}}_{0,1}$; $R_{5,1}$ = $D_1$ $\underline{\underline{M(1)}}_{1,1}$ + $D_2$ $\underline{\underline{M(1)}}_{2,1}$ + $D_3$ $\underline{\underline{M(1)}}_{3,1}$ + $D_4$ $\underline{\underline{M(1)}}_{0,1}$ ; ..., ce qui se visualise à l'aide du tableau suivant :

| | $R_{4,0}$ | $R_{4,1}$ | $R_{5,0}$ | $R_{5,1}$ | $R_{6,0}$ | $R_{6,1}$ | $R_{7,0}$ | ... |
|---|---|---|---|---|---|---|---|---|
| $D_0$ | | $\underline{\underline{M(1)}}_{0,0}$ | | | | | | |
| $D_1$ | | $\underline{\underline{M(1)}}_{1,0}$ | | $\underline{\underline{M(1)}}_{1,1}$ | | | | |
| $D_2$ | $\underline{\underline{M(0)}}_{0,0}$ | $\underline{\underline{M(1)}}_{2,0}$ | | $\underline{\underline{M(1)}}_{2,1}$ | | $\underline{\underline{M(1)}}_{2,2}$ | | |
| $D_3$ | $\underline{\underline{M(0)}}_{1,0}$ | $\underline{\underline{M(1)}}_{3,0}$ | $\underline{\underline{M(0)}}_{1,1}$ | $\underline{\underline{M(1)}}_{3,1}$ | | $\underline{\underline{M(1)}}_{3,2}$ | | |
| $D_4$ | | | $\underline{\underline{M(0)}}_{0,1}$ | $\underline{\underline{M(1)}}_{0,1}$ | $\underline{\underline{M(0)}}_{0,0}$ | $\underline{\underline{M(1)}}_{0,2}$ | | |
| $D_5$ | | | | | $\underline{\underline{M(0)}}_{1,0}$ | $\underline{\underline{M(1)}}_{1,2}$ | $\underline{\underline{M(0)}}_{1,1}$ | |
| $D_6$ | | | | | | | $\underline{\underline{M(0)}}_{0,1}$ | $\ddots$ |
| ... | | | | | | | | $\ddots$ |

Notons qu'au fur et à mesure que l'index i (numéro du burst dans la séquence) augmente, les fonctions de codage changent cycliquement, avec une période t(0), respectivement t(1).

Selon cet exemple, on réduit le temps de zapping grâce au bloc de redondance basé sur la série courte $S_0$ et on réalise une fiabilité élevée grâce au bloc de redondance basé sur la série plus longue $S_1$.

Il existe une autre manière de construire les matrices génératrices $\underline{\underline{A}}_{w,z}$. On note $t_{max} = max_{z=0,...,Z}(t(z))$. On construit une matrice génératrice d'un code correcteur $\underline{\underline{M'}}$ à $t_{max} \cdot Z \cdot L_D$ lignes et $t_{max} \cdot (L_{z=0} + L_{z=1} + ... + L_{z=Z-1})$ colonnes. M' se laisse découper en $t_{max} \cdot Z$ lignes et $t_{max} \cdot Z$ colonnes de sous-matrices $\underline{\underline{M'}}\mu,v$, $\mu = 0, ..., t_{max}-1$ et $v = 0, ..., t_{max}-1$, dont chacune est de taille $L_D \cdot L_z$.

$$\underline{\underline{M'}} = \begin{bmatrix} \underline{\underline{M'}}_{0,0} & \underline{\underline{M'}}_{0,1} & \cdots & \underline{\underline{M'}}_{0,Z \cdot t\max -1} \\ \underline{\underline{M'}}_{1,0} & \underline{\underline{M'}}_{1,1} & & \vdots \\ \vdots & & \ddots & \vdots \\ \underline{\underline{M'}}_{Z \cdot t\max -1,0} & \cdots & \cdots & \underline{\underline{M'}}_{Z \cdot t\max -1,Z \cdot t\max -1} \end{bmatrix}$$

Les sous-blocs de redondance $R_{i,z}$ peuvent être obtenus par :

$$R_{i,z} = \sum_{\beta=0}^{t(z)-1} D_{i-s(z)+\beta} \, \underline{\underline{M'}}_{\overline{i-s(z)+\beta}, \overline{i \cdot Z + z}}$$

où la notation « $\overline{x}$ » représente ici « x modulo $Z \cdot t_{max}$ ».

Avec, par exemple, Z = 2, s(0) = t(0) = 2, s(1) = t(1) = 4, la matrice $\underline{M'}$ est composée de 8 x 8 sous-blocs et le système de codage se résume à l'aide du tableau suivant :

|  | $R_{4,0}$ | $R_{4,1}$ | $R_{5,0}$ | $R_{5,1}$ | $R_{6,0}$ | $R_{6,1}$ | $R_{7,0}$ | ... |
|---|---|---|---|---|---|---|---|---|
| $D_0$ | | $\underline{M'}_{0,1}$ | | | | | | |
| $D_1$ | | $\underline{M'}_{1,1}$ | | $\underline{M'}_{1,3}$ | | | | |
| $D_2$ | $\underline{M'}_{2,0}$ | $\underline{M'}_{2,1}$ | | $\underline{M'}_{2,3}$ | | $\underline{M'}_{2,5}$ | | |
| $D_3$ | $\underline{M'}_{3,0}$ | $\underline{M'}_{3,1}$ | $\underline{M'}_{3,2}$ | $\underline{M'}_{3,3}$ | | $\underline{M'}_{3,5}$ | | |
| $D_4$ | | | $\underline{M'}_{4,2}$ | $\underline{M'}_{4,3}$ | $\underline{M'}_{4,4}$ | $\underline{M'}_{4,5}$ | | |
| $D_5$ | | | | | $\underline{M'}_{5,4}$ | $\underline{M'}_{5,5}$ | $\underline{M'}_{5,6}$ | $\ddots$ |
| $D_6$ | | | | | | | $\underline{M'}_{6,6}$ | $\ddots$ |
| ... | | | | | | | | |

Jusqu'à présent, seulement le cas PE = 1 a été discuté. On peut sans difficulté généraliser les exemples ci-dessus aux cas PE > 1 en rajoutant l'index de numérotation j, j = 0, ..., PE-1, des blocs de symboles d'information ou de redondance dans les formules indiquées. Pour chaque j, on obtient ainsi :

$$R_i^j = \sum_{w=i-s}^{i-s+(t-1)} D_w^j \, \underline{\underline{A}}_w^j$$

respectivement

$$R_{i,z}^j = \sum_{w=i-s(z)}^{i-s(z)+(t(z)-1)} D_w^j \, \underline{\underline{A}}_{w,z}^j \, .$$

En principe, les matrices $\underline{\underline{A}}_w^j$ ou $\underline{\underline{A}}_{w,z}^j$ peuvent être choisies individuellement pour chaque j. De préférence, on utilise toutefois les mêmes matrices $\underline{\underline{A}}_w$ ou $\underline{\underline{A}}_{w,z}$ pour tous les indices j.

Au niveau du récepteur, les fonctions de codage (et donc les matrices les représentant) sont connues. Lorsqu'un burst n'est pas correctement ou pas du tout reçu, le récepteur résout un système d'équations pour reconstruire les données d'information perdues. Des algorithmes de reconstruction adéquats sont à la portée de l'homme du métier sur la base de la description du procédé d'encodage selon l'invention. Si des séries de bursts de longueur différente sont utilisées pour obtenir plusieurs systèmes de sous-blocs de redondance, la reconstruction de données perdues peut se faire sur la base des blocs de redondance d'une seule ou de plusieurs séries, selon besoin. Si les données perdues peuvent être reconstruites sur la base de la série la plus courte on bénéficiera d'un temps de latence très court. Si la perte est d'une plus grande envergure (p. ex. sur plusieurs bursts consécutifs), la redondance de la série la plus courte ne sera éventuellement plus suffisante pour la reconstruction et la ou les séries plus longues devront être prises en compte pour la reconstruction. La ou les séries plus longues garantissent donc une fiabilité globale élevée du système.

**Revendications**

1. Procédé d'encodage de données d'information en une séquence de bursts (..., $B_{i-2}$, $B_{i-1}$, $B_i$, $B_{i+1}$, ...), chaque burst comprenant un bloc de symboles d'information ($D_{i-2}$, $D_{i-1}$, $D_i$, $D_{i+1}$) et un bloc de symboles de redondance ($R_{i-2}$, $R_{i-1}$, $R_i$, $R_{i+1}$), le procédé comprenant
la génération du bloc de symboles de redondance ($R_i$) d'un burst actuel ($B_i$) de la séquence à partir de symboles d'information des blocs de symboles d'information de plusieurs bursts de la séquence ;
la génération du bloc de symboles de redondance ($R_i$) du burst actuel ($B_i$) comprenant le calcul d'une somme d'une série de valeurs de codage relative à une série de bursts ($B_{i-2}$, $B_{i-1}$), chaque valeur de codage de la série de valeurs de codage étant obtenue en tant que résultat d'une fonction de codage respective, appliquée au bloc de symboles d'information ($D_{i-2}$, respectivement $D_{i-1}$) du burst correspondant de la série de bursts ($B_{i-2}$, $B_{i-1}$),
**caractérisé en ce que** chaque fonction de codage est une fonction, qui, appliquée sur un bloc de symboles, donne, en tant que valeur de codage, les symboles de redondance d'un code correcteur et qui a la propriété d'utiliser tous les symboles du bloc auquel elle est appliquée, au sens que, si la valeur d'un seul, quelconque, symbole du bloc est changée, la valeur de codage obtenue change aussi ;
chaque fonction de codage respective des valeurs de codage de la série de valeurs de codage étant une sous-matrice différente issue d'une matrice génératrice d'un code correcteur.

2. Procédé selon la revendication 1, dans lequel ladite série de bursts ($B_{i-2}$, $B_{i-1}$) est une série de bursts précédant le burst actuel ($B_i$), et de préférence une série de bursts précédant immédiatement le burst actuel ($B_i$).

3. Procédé d'encodage de données d'information en une séquence de bursts (..., $B_{i-2}$, $B_{i-1}$, $B_i$, $B_{i+1}$, ...), chaque burst comprend une structure ordonnée de blocs de symboles d'information ($D_i^0$, ..., $D_i^j$, ..., $D_i^{PE-1}$) et une structure ordonnée de blocs de symboles de redondance ($R_i^0$, ..., $R_i^j$, ..., $R_i^{PE-1}$), le nombre de blocs de symboles d'information dans la structure ordonnée de blocs de symboles d'information étant égal au nombre de blocs de symboles de redondance dans la structure ordonnée de blocs de symboles de redondance, le procédé comprenant
la génération du bloc de symboles de redondance ($R_i^j$) d'un burst actuel ($B_i$) de la séquence à partir de symboles d'information des blocs de symboles d'information d'une série de bursts (Bi-2, Bi-1);
la génération de chaque bloc de la structure ordonnée de blocs de symboles de redondance du burst actuel comprenant le calcul d'une somme d'une série de valeurs de codage relative aux blocs ($D_i^j$) se trouvant à la position (j) correspondante dans la structure ordonnée de blocs de symboles d'information des bursts de la série de bursts ($B_{i-2}$, $B_{i-1}$),
chaque valeur de codage de la série de valeurs de codage étant obtenue par une fonction de codage respective, appliquée au bloc de symboles d'information se trouvant à la position (j) correspondante dans la structure ordonnée de blocs de symboles d'information du burst correspondant de la série de bursts ($B_{i-2}$, $B_{i-1}$),
**caractérisé en ce que** chaque fonction de codage est une fonction, qui, appliquée sur un bloc de symboles, donne, en tant que valeur de codage, les symboles de redondance d'un code correcteur et qui a la propriété d'utiliser tous les symboles du bloc auquel elle est appliquée, au sens que, si la valeur d'un seul, quelconque, symbole du bloc est changée, la valeur de codage obtenue change aussi ;
chaque fonction de codage respective des valeurs de codage de la série de valeurs de codage étant une sous-matrice différente issue d'une matrice génératrice d'un code correcteur.

4. Procédé d'encodage de données d'information en une séquence de bursts (..., $B_{i-2}$, $B_{i-1}$, $B_i$, $B_{i+1}$, ...), chaque burst comprenant un bloc de symboles d'information ($D_i$) et un bloc de symboles de redondance ($R_i$), le procédé comprenant
la génération du bloc de symboles de redondance ($R_i$) d'un burst actuel ($B_i$) de la séquence à partir de symboles d'information des blocs de symboles d'information de plusieurs bursts de la séquence ;
la génération du bloc de symboles de redondance ($R_i$) du burst actuel comprenant

la génération d'un premier sous-bloc ($R_{i,0}$) du bloc de symboles de redondance ($R_i$) du burst actuel ($B_i$), qui inclut

le calcul d'une valeur de codage par une fonction de codage appliquée sur le bloc de symboles d'information d'un burst de la séquence autre que le burst actuel, ou
le calcul d'une somme d'une première série de valeurs de codage relative à une première série ($S_0$) de bursts ($B_{i-2}$, $B_{i-1}$), chaque valeur de codage de la première série de valeurs de codage étant obtenue par une fonction de codage respective, appliquée au bloc de symboles d'information du burst correspondant de la première série ($S_0$) de bursts ;

et la génération d'un deuxième sous-bloc ($R_{i,1}$) du bloc de symboles de redondance ($R_i$) du burst actuel ($B_i$), qui inclut le calcul d'une somme d'une deuxième série de valeurs de codage relative à une deuxième série ($S_1$) de bursts ($B_{i-4}$, $B_{i-3}$, $B_{i-2}$, $B_{i-1}$), chaque valeur de codage de la deuxième série de valeurs de codage étant obtenue par une fonction de codage respective, appliquée au bloc de symboles d'information du burst correspondant de la deuxième série ($S_1$) de bursts,

la première ($S_0$) et deuxième ($S_1$) séries de bursts étant de longueur différente, et **caractérisé en ce que** chaque fonction de codage est une fonction, qui, appliquée sur un bloc de symboles, donne, en tant que valeur de codage, les symboles de redondance d'un code correcteur et qui la propriété d'utiliser tous les symboles du bloc auquel elle est appliquée, au sens que, si la valeur d'un seul, quelconque, symbole du bloc est changée, la valeur de codage obtenue change aussi ;

chaque fonction de codage respective des valeurs de codage de la série de valeurs de codage étant une sous-matrice différente issue d'une matrice génératrice d'un code correcteur.

**5.** Procédé selon la revendication 4, dans lequel la première ($S_0$) et deuxième ($S_1$) séries de bursts sont des séries de bursts précédant, de préférence immédiatement, le burst actuel ($B_i$).

**6.** Procédé d'encodage de données d'information en une séquence de bursts (..., $B_{i-2}$, $B_{i-1}$, $B_i$, $B_{i+1}$, ...), chaque burst comprend une structure ordonnée de blocs de symboles d'information ($D_i^0$, ..., $D_i^j$, ..., $D_i^{PE-1}$) et une structure ordonnée de blocs de symboles de redondance ($R_i^0$, ..., $R_i^j$, ..., $R_i^{PE-1}$). le nombre de blocs de symboles d'information dans la structure ordonnée de blocs de symboles d'information étant égal au nombre de blocs de symboles de redondance dans la structure ordonnée de blocs de symboles de redondance , le procédé comprenant :

la génération de chaque bloc de la structure ordonnée de blocs de symboles de redondance du burst actuel ($B_i$) comprend la génération d'un premier sous-bloc et d'un deuxième sous-bloc ;

la génération du premier sous-bloc incluant

le calcul d'une valeur de codage par une fonction de codage appliquée sur le bloc de symboles d'information se trouvant à la position (j) correspondante dans la structure ordonnée d'un burst autre que le burst actuel, ou

le calcul d'une somme d'une première série de valeurs de codage relative aux blocs se trouvant à la position correspondante dans la structure ordonnée de blocs de symboles d'information des bursts d'une première série ($S_0$) de bursts, chaque valeur de codage de la première série de valeurs de codage étant obtenue par une fonction de codage respective, appliquée au bloc de symboles d'information se trouvant à la position (j) correspondante dans la structure ordonnée de blocs de symboles d'information du burst correspondant de la première série ($S_0$) de bursts ;

et la génération du deuxième sous-bloc incluant le calcul d'une somme d'une deuxième série de valeurs de codage relative aux blocs se trouvant à la position (j) correspondante dans la structure ordonnée de blocs de symboles d'information des bursts d'une deuxième série ($S_1$) de bursts, chaque valeur de codage de la deuxième série de valeurs de codage étant obtenue par une fonction de codage respective, appliquée au bloc de symboles d'information se trouvant à la position (j) correspondante dans la structure ordonnée de blocs de symboles d'information du burst correspondant de la deuxième série ($S_1$) de bursts

la première ($S_0$) et deuxième ($S_1$) séries de bursts étant de longueur différente, et **caractérisé en ce que** chaque fonction de codage est une fonction, qui, appliquée sur un bloc de symboles, donne, en tant que valeur de codage, les symboles de redondance d'un code correcteur et qui la propriété d'utiliser tous les symboles du bloc auquel elle est appliquée, au sens que, si la valeur d'un seul, quelconque, symbole du bloc est changée, la valeur de codage obtenue change aussi ;

chaque fonction de codage respective des valeurs de codage de la série de valeurs de codage étant une sous-matrice différente issue d'une matrice génératrice d'un code correcteur.

**7.** Procédé selon l'une quelconque des revendications 1 à 6, comprenant la répétition de l'étape de génération du bloc de symboles de redondance pour un ou plusieurs bursts suivants ($B_{i+1}$, ...) qui deviennent à tour de rôle le burst actuel.

8. Procédé selon la revendication 7, dans lequel les fonctions de codage restent inchangées lors de la répétition de l'étape de génération du bloc de symboles de redondance pour les bursts suivants ($B_{i+1}$, ...).

9. Procédé selon la revendication 7, dans lequel les fonctions de codage sont changées de manière cyclique lors de la répétition de l'étape de génération du bloc de symboles de redondance pour les bursts suivants ($B_{i+1}$, ...).

10. Procédé selon la revendication 3 ou 6, dans lequel le nombre de blocs de symboles d'information dans la structure ordonnée de blocs de symboles d'information est compris dans la plage de 1 à 1000.

11. Procédé selon l'une quelconque des revendications 1 à 10, dans lequel les symboles d'information et les symboles de redondance sont des éléments d'un corps fini.

**Patentansprüche**

1. Verfahren zur Kodierung von Informationsdaten in einer Burstsequenz (..., $B_{i-2}$, $B_{i-1}$, $B_i$, $B_{i+1}$, ...), wobei jeder Burst einen Informationssymbolblock ($D_{i-2}$, $D_{i-1}$, $D_i$, $D_{i+1}$) und einen Redundanzsymbolblock ($R_{i-2}$, $R_{i-1}$, $R_i$, $R_{i+1}$) umfasst, wobei das Verfahren umfasst
Generieren des Redundanzsymbolblocks ($R_i$) eines aktuellen Bursts ($B_i$) der Sequenz auf der Basis von Informationssymbolen der Informationssymbolblöcke mehrerer Bursts der Sequenz;
Generieren des Redundanzsymbolblocks ($R_i$) des aktuellen Bursts ($B_i$), umfassend das Berechnen einer Summe einer Kodierwertreihe relativ zu einer Reihe von Bursts ($B_{i-2}$, $B_{i-1}$), wobei jeder Kodierwert der Kodierwertreihe als Ergebnis einer jeweiligen Kodierfunktion, angewendet auf den Informationssymbolblock ($D_{i-2}$ beziehungsweise $D_{i-1}$) des entsprechenden Bursts der Reihe von Bursts ($B_{i-2}$, $B_{i-1}$), erhalten wird,
**dadurch gekennzeichnet, dass** jede Kodierfunktion eine Funktion ist, die, angewendet auf einen Symbolblock, als Kodierwert die Redundanzsymbole eines Korrekturcodes ergibt und welche die Eigenschaft hat, alle Symbole des Blocks zu verwenden, auf den sie angewendet wird, derart, dass, wenn der Wert eines einzigen beliebigen Symbols des Blocks geändert wird, sich der erhaltene Kodierwert auch ändert;
wobei jede jeweilige Kodierfunktion der Kodierwerte der Kodierwertreihe eine unterschiedliche Untermatrix ist, hervorgegangen aus einer einen Korrekturcode generierenden Matrix.

2. Verfahren nach Anspruch 1, wobei die Reihe von Bursts ($B_{i-2}$, $B_{i-1}$) eine Reihe von Bursts vor dem aktuellen Burst ($B_i$) und vorzugsweise eine Reihe von Bursts unmittelbar vor dem aktuellen Burst ($B_i$) ist.

3. Verfahren zur Kodierung von Informationsdaten in einer Burstsequenz (..., $B_{i-2}$, $B_{i-1}$, $B_i$, $B_{i+1}$, ...), wobei jeder Burst eine geordnete Struktur von Informationssymbolblöcken ($D_i^0$, ..., $D_i^j$, ..., $D_i^{PE-1}$) und eine geordnete Struktur von Redundanzsymbolblöcken ($R_i^0$, ..., $R_i^j$, ..., $R_i^{PE-1}$) umfasst, wobei die Anzahl von Informationssymbolblöcken in der geordneten Struktur von Informationssymbolblöcken gleich der Anzahl von Redundanzsymbolblöcken in der geordneten Struktur von Redundanzsymbolblöcken ist, wobei das Verfahren umfasst
Generieren des Redundanzsymbolblocks ($R_i^j$) eines aktuellen Bursts (Bi) der Sequenz auf der Basis von Informationssymbolen der Informationssymbolblöcke einer Reihe von Bursts (Bi-2, Bi-1);
wobei das Generieren jedes Blocks der geordneten Struktur von Redundanzsymbolblöcken des aktuellen Bursts das Berechnen einer Summe einer Kodierwertreihe relativ zu den Blöcken ($D_i^j$) umfasst, die sich an der entsprechenden Position (j) in der geordneten Struktur von Informationssymbolblöcke der Bursts der Reihe von Bursts ($B_{i-2}$, $B_{i-1}$) befindet,
wobei jeder Kodierwert der Kodierwertreihe durch eine jeweilige Kodierfunktion erhalten wird, angewendet auf den Informationssymbolblock, der sich an der entsprechenden Position (j) in der geordneten Struktur von Informationssymbolblöcken des entsprechenden Bursts der Reihe von Bursts ($B_{i-2}$, $B_{i-1}$) befindet,
**dadurch gekennzeichnet, dass** jede Kodierfunktion eine Funktion ist, die, angewendet auf einen Symbolblock, als Kodierwert die Redundanzsymbole eines Korrekturcodes ergibt und welche die Eigenschaft hat, alle Symbole des Blocks zu verwenden, auf den sie angewendet wird, derart, dass, wenn der Wert eines einzigen beliebigen Symbols des Blocks geändert wird, sich der erhaltene Kodierwert auch ändert;
wobei jede jeweilige Kodierfunktion der Kodierwerte der Kodierwertreihe eine unterschiedliche Untermatrix ist, hervorgegangen aus einer einen Korrekturcode generierenden Matrix.

4. Verfahren zur Kodierung von Informationsdaten in einer Burstsequenz (..., $B_{i-2}$, $B_{i-1}$, $B_i$, $B_{i+1}$, ...), wobei jeder Burst einen Informationssymbolblock ($D_i$) und einen Redundanzsymbolblock (Ri) umfasst, wobei das Verfahren umfasst
Generieren des Redundanzsymbolblocks ($R_i$) eines aktuellen Bursts ($B_i$) der Sequenz auf der Basis von Informa-

EP 2 724 467 B1

tionssymbolen der Informationssymbolblöcke mehrerer Bursts der Sequenz;
Generieren des Redundanzsymbolblocks ($R_i$) des aktuellen Bursts, umfassend
Generieren eines ersten Unterblocks ($R_{i,0}$) des Redundanzsymbolblocks ($R_i$) des aktuellen Bursts ($B_i$), was einschließt
Berechnen eines Kodierwerts durch eine Kodierfunktion, angewendet auf den Informationssymbolblock eines anderen Bursts der Sequenz als den aktuellen Burst, oder
Berechnen einer Summe einer ersten Reihe von Kodierwerten relativ zu einer ersten Reihe ($S_0$) von Bursts ($B_{i-2}$, $B_{i-1}$), wobei jeder Kodierwert der ersten Reihe von Kodierwerten durch eine jeweilige Kodierfunktion erhalten wird, angewendet auf den Informationssymbolblock des entsprechenden Bursts der ersten Reihe ($S_0$) von Bursts;
und Generieren eines zweiten Unterblocks ($R_{i,1}$) des Redundanzsymbolblocks ($R_i$) des aktuellen Bursts ($B_i$), was das Berechnen einer Summe einer zweiten Reihe von Kodierwerten relativ zu einer zweiten Reihe ($S_1$) von Bursts ($B_{i-4}$, $B_{i-3}$, $B_{i-2}$, $B_{i-1}$) einschließt, wobei jeder Kodierwert der zweiten Reihe von Kodierwerten durch eine jeweilige Kodierfunktion erhalten wird, angewendet auf den Informationssymbolblock des entsprechenden Bursts der zweiten Reihe ($S_1$) von Bursts,
wobei die erste ($S_0$) und zweite ($S_1$) Reihe von Bursts unterschiedlich lang sind, und
**dadurch gekennzeichnet, dass** jede Kodierfunktion eine Funktion ist, die, angewendet auf einen Symbolblock, als Kodierwert die Redundanzsymbole eines Korrekturcodes ergibt und welche die Eigenschaft hat, alle Symbole des Blocks zu verwenden, auf den sie angewendet wird, derart, dass, wenn der Wert eines einzigen beliebigen Symbols des Blocks geändert wird, sich der erhaltene Kodierwert auch ändert;
wobei jede jeweilige Kodierfunktion der Kodierwerte der Kodierwertreihe eine unterschiedliche Untermatrix ist, hervorgegangen aus einer einen Korrekturcode generierenden Matrix.

5. Verfahren nach Anspruch 4, wobei die erste ($S_0$) und zweite ($S_1$) Reihe von Bursts Reihen von Bursts vor, vorzugsweise unmittelbar, dem aktuellen Burst ($B_i$) sind.

6. Verfahren zur Kodierung von Informationsdaten in einer Burstsequenz (..., $B_{i-2}$, $B_{i-1}$, Bi, $B_{i+1}$, ...), wobei jeder Burst eine geordnete Struktur von Informationssymbolblöcken ($D_i^0$, ..., $D_i^j$, ..., $D_i^{PE-1}$) und eine geordnete Struktur von Redundanzsymbolblöcken ($R_i^0$, ..., $R_i^j$, ..., $R_i^{PE-1}$) umfasst, wobei die Anzahl von Informationssymbolblöcken in der geordneten Struktur von Informationssymbolblöcken gleich der Anzahl von Redundanzsymbolblöcken in der geordneten Struktur von Redundanzsymbolblöcken ist, wobei das Verfahren umfasst:

   das Generieren jedes Blocks der geordneten Struktur von Redundanzsymbolblöcken des aktuellen Bursts ($B_i$) umfasst das Generieren eines ersten Unterblocks und eines zweiten Unterblocks;
   wobei das Generieren des ersten Unterblocks einschließt
   Berechnen eines Kodierwerts durch eine Kodierfunktion, angewendet auf den Informationssymbolblock, der sich an der entsprechenden Position (j) in der geordneten Struktur eines anderen Bursts als der aktuelle Burst befindet, oder
   Berechnen einer Summe einer ersten Reihe von Kodierwerten relativ zu den Blöcken, die sich an der entsprechenden Position in der geordneten Struktur von Informationssymbolblöcken der Bursts einer ersten Reihe ($S_0$) von Bursts befinden, wobei jeder Kodierwert der ersten Reihe von Kodierwerten durch eine jeweilige Kodierfunktion erhalten wird, angewendet auf den Informationssymbolblock an der entsprechenden Position (j) in der geordneten Struktur von Informationssymbolblöcken des entsprechenden Bursts der ersten Reihe ($S_0$) von Bursts;
   und Generieren des zweiten Unterblocks, einschließend das Berechnen einer Summe einer zweiten Reihe von Kodierwerten relativ zu den Blöcken, die sich an der entsprechenden Position (j) in der geordneten Struktur von Informationssymbolblöcken der Bursts einer zweiten Reihe ($S_1$) von Bursts befinden, wobei jeder Kodierwert der zweiten Reihe von Kodierwerten durch eine jeweilige Kodierfunktion erhalten wird, angewendet auf den Informationssymbolblock, der sich an der entsprechenden Position (j) in der geordneten Struktur von Informationssymbolblöcke des entsprechenden Bursts der zweiten Reihe ($S_1$) von Bursts befindet, wobei die erste ($S_0$) und zweite ($S_1$) Reihe von Bursts unterschiedlich lang sind, und
   **dadurch gekennzeichnet, dass** jede Kodierfunktion eine Funktion ist, die, angewendet auf einen Symbolblock, als Kodierwert die Redundanzsymbole eines Korrekturcodes ergibt und welche die Eigenschaft hat, alle Symbole des Blocks zu verwenden, auf den sie angewendet wird, derart, dass, wenn der Wert eines einzigen beliebigen Symbols des Blocks geändert wird, sich der erhaltene Kodierwert auch ändert;
   wobei jede jeweilige Kodierfunktion der Kodierwerte der Kodierwertreihe eine unterschiedliche Untermatrix ist, hervorgegangen aus einer einen Korrekturcode generierenden Matrix.

7. Verfahren nach einem der Ansprüche 1 bis 6, umfassend die Wiederholung des Schritts des Generierens des Redundanzsymbolblocks für ein oder mehrere nächste Bursts ($B_{i+1}$, ...), die nacheinander zum aktuellen Burst werden.

8. Verfahren nach Anspruch 7, wobei die Kodierfunktionen bei der Wiederholung des Schritts des Generierens des Redundanzsymbolblocks für die nächsten Bursts ($B_{i+1}$, ...) unverändert bleiben.

9. Verfahren nach Anspruch 7, wobei die Kodierfunktionen bei der Wiederholung des Schritts des Generierens des Redundanzsymbolblocks für die nächsten Bursts ($B_{i+1}$, ...) zyklisch geändert werden.

10. Verfahren nach Anspruch 3 oder 6, wobei die Anzahl von Informationssymbolblöcke in der geordneten Struktur von Informationssymbolblöcken im Bereich von 1 bis 1000 liegt.

11. Verfahren nach einem der Ansprüche 1 bis 10, wobei die Informationssymbole und die Redundanzsymbole Elemente eines finiten Körpers sind.

## Claims

1. A method for encoding information data into a sequence of bursts (..., $B_i$-$_2$, $B_{i-1}$, $B_i$, $B_{i+1}$, ...), each burst comprising a block of information symbols ($D_{i-2}$, $D_{i-1}$, $D_i$, $D_{i+1}$) and a block of redundancy symbols ($R_{i-2}$, $R_{i-1}$, $R_i$, $R_{i+1}$), the method comprising
   generating the block of redundancy symbols ($R_i$) of a current burst ($B_i$) of the sequence from information symbols of the blocks of information symbols of several bursts of the sequence;
   generating the block of redundancy symbols ($R_i$) of the current burst ($B_i$) comprising calculating a sum of a series of coding values related to a series of bursts ($B_{i-2}$, $B_{i-1}$), each coding value of the series of coding values being obtained as a result of a respective coding function, applied to the block of information symbols ($D_{i-2}$, respectively $D_{i-1}$) of the corresponding burst of the series of bursts ($B_{i-2}$, $B_{i-1}$),
   **characterized in that** each coding function is a function, which, when applied on a block of symbols, gives, as a coding value, the redundancy symbols of a correcting code and which has the property of using all the symbols of the block to which it is applied, in the meaning that, if the value of any single symbol of the block is changed, the coding value obtained changes too;
   each respective coding function of the coding values of the series of coding values being a different sub-matrix resulting from a generator matrix of a correcting code.

2. The method according to claim 1, wherein said series of bursts ($B_{i-2}$, $B_{i-1}$) is a series of bursts preceding the current burst ($B_i$), and preferably a series of bursts immediately preceding the current burst ($B_i$).

3. The method for encoding information data into a sequence of bursts (..., $B_{i-2}$, $B_{i-1}$, $B_i$, $B_{i+1}$, ...), each burst comprising an ordered structure of blocks of information symbols ($D_i^0$, ..., $D_i^j$, ..., $D_i^{PE-1}$) and an ordered structure of blocks of redundancy symbols ($R_i^0$, ..., $R_i^j$, ..., $R_i^{PE-1}$), the number of blocks of information symbols in the ordered structure of blocks of information symbols being equal to the number of blocks of redundancy symbols in the ordered structure of blocks of redundancy symbols, the method comprising
   generating the block of redundancy symbols ($R_i^j$) of a current burst ($B_i$) of the sequence from information symbols of the blocks of information symbols of a series of bursts ($B_{i-2}$, $B_{i-1}$);
   generating each block of the ordered structure of blocks of redundancy symbols of the current burst comprising calculating a sum of a series of coding values related to the blocks ($D_i^j$) located at the corresponding position (j) in the ordered structure of blocks of information symbols of the bursts of the series of bursts ($B_{i-2}$, $B_{i-1}$),
   each coding value of the series of coding values being obtained by a respective coding function, applied to the block of information symbols located at the corresponding position (j) in the ordered structure of blocks of information symbols of the corresponding burst of the series of bursts ($B_{i-2}$, $B_{i-1}$),
   **characterized in that** each coding function is a function, which, when applied on a block of symbols, gives, as a coding value, the redundancy symbols of a correcting code and which has the property of using all the symbols of the block to which it is applied, in the meaning that, if the value of any single symbol of the block is changed, the coding value obtained changes too;
   each respective coding function of the coding values of the series of coding values being a different sub-matrix resulting from a generator matrix of a correcting code.

4. The method for encoding information data into a sequence of bursts (..., $B_{i-2}$, $B_{i-1}$, $B_i$, $B_{i+1}$, ...), each burst comprising

a block of information symbols ($D_i$) and a block of redundancy symbols ($R_i$), the method comprising generating the block of redundancy symbols ($R_i$) of a current burst ($B_i$) of the sequence from information symbols of the blocks of information symbols of several bursts of the sequence;

generating the block of redundancy symbols ($R_i$) of the current burst comprising

- generating a first sub-block ($R_{i,0}$) of the block of redundancy symbols ($R_i$) of the current burst ($B_i$), which includes

  ▪ calculating a coding value by a coding function applied on the block of information symbols of a burst of the sequence other than the current burst, or
  ▪ calculating a sum of a first series of coding values related to a first series ($S_0$) of bursts ($B_{i-2}$, $B_{i-1}$), each coding value of the first series of coding values being obtained by a respective coding function, applied to the block of information symbols of the corresponding burst of the first series ($S_0$) of bursts;

  - and generating a second sub-block ($R_{i,1}$) of the block of redundancy symbols ($R_i$) of the current burst ($B_i$), which includes calculating a sum of a second series of coding values related to a second series ($S_1$) of bursts ($B_{i-4}$, $B_{i-3}$, $B_{i-2}$, $B_{i-1}$), each coding value of the second series of coding values being obtained by a respective coding function, applied to the block of information symbols of the corresponding burst of the second series ($S_1$) of bursts,

the first ($S_0$) and second ($S_1$) series of bursts being of different length, and

**characterized in that** each coding function is a function, which, when applied on a block of symbols, gives, as a coding value, the redundancy symbols of a correcting code and which has the property of using all the symbols of the block to which it is applied, in the meaning that, if the value of any single symbol of the block is changed, the coding value obtained changes too;

each respective coding function of the coding values of the series of coding values being a different sub-matrix resulting from a generator matrix of a correcting code.

5. The method according to claim 4, wherein the first ($S_0$) and second ($S_1$) series of bursts are series of bursts preceding, preferably immediately preceding, the current burst ($B_i$).

6. The method for encoding information data into a sequence of bursts (..., $B_{i-2}$, $B_{i-1}$, $B_i$, $B_{i+1}$, ...), each burst comprising an ordered structure of blocks of information symbols ($D_i^0$, ..., $D_i^j$, ..., $D_i^{PE-1}$) and an ordered structure of blocks of redundancy symbols ($R_i^0$, ..., $R_i^j$, ..., $R_i^{PE-1}$), the number of blocks of information symbols in the ordered structure of blocks of information symbols being equal to the number of blocks of redundancy symbols in the ordered structure of blocks of redundancy symbols, the method comprising:

generating each block of the ordered structure of blocks of redundancy symbols of the current burst ($B_i$) comprises generating a first sub-block and a second sub-block;

- generating the first sub-block including

  ▪ calculating a coding value by a coding function applied on the block of information symbols located at the corresponding position (j) in the ordered structure of a burst other than the current burst, or
  ▪ calculating a sum of a first series of coding values related to the blocks located at the corresponding position in the ordered structure of blocks of information symbols of the bursts of a first series ($S_0$) of bursts, each coding value of the first series of coding values being obtained by a respective coding function, applied to the block of information symbols located at the corresponding position (j) in the ordered structure of blocks of information symbols of the corresponding burst of the first series ($S_0$) of bursts;

  - and generating the second sub-block including calculating a sum of a second series of coding values related to the blocks located at the corresponding position (j) in the ordered structure of blocks of information symbols of the bursts of a second series ($S_1$) of bursts,

each coding value of the second series of coding values being obtained by a respective coding function, applied to the block of information symbols located at the corresponding position (j) in the ordered structure of blocks of information symbols of the corresponding burst of the second series ($S_1$) of bursts

the first ($S_0$) and second ($S_1$) series of bursts being of different length, and

**characterized in that** each coding function is a function, which, when applied on a block of symbols, gives, as a coding value, the redundancy symbols of a correcting code and which has the property of using all the symbols of the block to which it is applied, in the meaning that, if the value of any single symbol of the block is changed, the coding value obtained changes too;

each respective coding function of the coding values of the series of coding values being a different sub-matrix resulting from a generator matrix of a correcting code.

7. The method according to any one of claims 1 to 6, comprising the repetition of the step of generating the block of redundancy symbols for one or more following burst(s) ($B_{i+1}$, ...) which in turn become(s) the current burst.

8. The method according to claim 7, wherein the coding functions remain unchanged when repeating the step of generating the block of redundancy symbols for the following bursts ($B_{i+1}$, ...).

9. The method according to claim 7, wherein the coding functions are cyclically changed when repeating the step of generating the block of redundancy symbols for the following bursts ($B_{i+1}$, ...).

10. The method according to claim 3 or 6, wherein the number of blocks of information symbols in the ordered structure of blocks of information symbols is comprised in the range of 1 to 1000.

11. The method according to any one of claims 1 to 10, wherein the information symbols and the redundancy symbols are elements of a finite body.

Fig. 1

EP 2 724 467 B1

Fig. 2

Fig. 3

Fig. 4

EP 2 724 467 B1

## RÉFÉRENCES CITÉES DANS LA DESCRIPTION

**Documents brevets cités dans la description**

- US 20090006927 A
- US 20100031121 A

- US 5870412 A

**Littérature non-brevet citée dans la description**

- Digital Video Broadcasting (DVB); DVB-SH Implementation Guidelines. *ETSI TS 102 584 V1.1.1,* Décembre 2008

- **M. ISMAIL.** A Multi-Burst Sliding Encoding for Mobile Satellite TV Broadcasting. *ETSI TR 102 993 V.1.1.1,* Février 2011